Europäisches Patentamt

European Patent Office

Office européen des brevets

(11) Publication number: **0 450 320 A1**

# EUROPEAN PATENT APPLICATION

(21) Application number: **91103236.5**

(22) Date of filing: **04.03.91**

(51) Int. Cl.5: **H01L 21/60, H01L 23/485,** **H01L 23/522**

(30) Priority: **05.03.90 JP 51672/90**

(43) Date of publication of application:
**09.10.91 Bulletin 91/41**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Watanabe, Shuji, c/o Int. Property**
**Division**
**Kabushiki Kaisha Toshiba, 1-1 Shibaura**
**1-chome**
**Minato-ku, Tokyo 105(JP)**
Inventor: **Takada, Hideki, c/o Int. Property**
**Division**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor integrated circuit device for high frequency signal processing.

(57) A semiconductor integrated circuit device comprises a multilevel interconnection structure which includes upper interconnection layers (44, 43) provided on an interlevel insulator (42). A part of at least one of upper interconnection layers (44) disposed on the interlevel insulator (42) is used as an electrode pad (44) to reduce an unwanted stray capacitance between the electrode pad (44) and a semiconductor substrate (30).

F I G. 2

The present invention relates to an electrode pad for a semiconductor integrated circuit device having a multilevel interconnection structure, and more particularly, to a semiconductor integrated circuit device for high frequency signal processing.

In a semiconductor integrated circuit device, electrode pads for external connection are usually provided on a peripheral portion of a chip. These electrode pads are connected to the external terminals of the semiconductor integrated circuit device through bonding wires. In this case, the configuration, position and, size of the electrode pad are determined, depending upon the accuracy of the bonding technique. It is, however, usually necessary that the size of the electrode pad is of the order of 100 $\mu$m in square. The electrode pad is provided by an metal layer which is formed above an insulating film of a semiconductor substrate and is used as the interconnection layer of circuit elements.

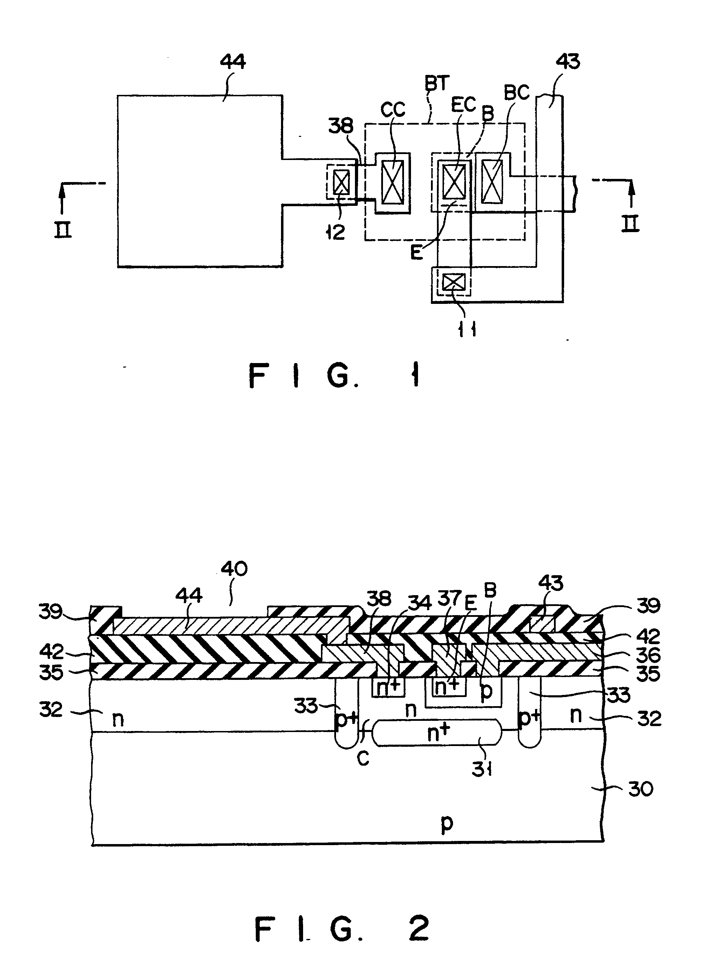

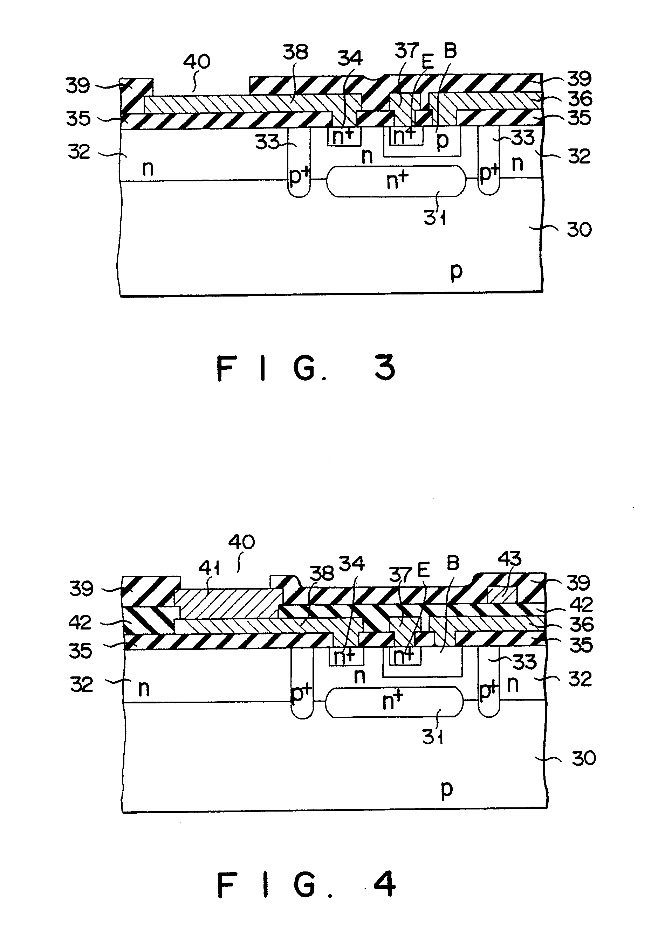

Fig. 3 is a cross-sectional view showing a bipolar transistor and an electrode pad in a conventional integrated circuit device. In the structure, reference numeral 30 represents a P-type semiconductor substrate, 31 an $n^+$-type buried layer, 32 an n-type epitaxial layer, 33 a $p^+$-type isolation region provided in the epitaxial layer so as to surround an island-like bipolar transistor area with the $p^+$-layer isolation region 33, B a base region formed in the bipolar transistor area, E an emitter region provided in the base region, 34 an $n^+$-type contact region being in contact with the epitaxial layer, 35 an insulating film provided on the surface of the epitaxial layer, 36 a base lead-out electrode being in contact with the base region B through a base opening in the insulating film 35, 37 an emitter electrode being in contact with the emitter region E through an emitter opening in the insulating film 35, 38 a collector lead-out electrode being in c ontact with the contact region 34 through a collector opening in the insulating film 35, and 39 a surface passivation film provided over the respective electrode wiring layers and having a opening 40 to expose a part of the collector lead-out electrode 38, thereby providing an electrode pad, respectively.

In the electrode pad having the structure, a MOS type capacitor is provided which is comprised of the electrode wiring layer, the insulating film and the epitaxial layer. The capacitance value C of the MOS capacitor is given by:

$$C = A \cdot \frac{\varepsilon_0 \cdot \varepsilon}{d} \qquad \cdots \quad (1)$$

(where
A: the electrode area
d: the thickness of the insulating film
$\varepsilon_0$: the dielectric constant in vacuum
$\varepsilon$: the relative dielectric constant)
If A = 100 $\mu$m × 100 $\mu$m, d = 7000 Å, and
$\varepsilon$ = 3.9 (the insulating film 35: an $SiO_2$ film) are given, respectively, (where $\varepsilon_0$ = 8.85 × $10^{-14}$ F/cm), the capacitance value C of the MOS capacitor will become

$$C = 10^{-4} \ (cm^2) \times \frac{8.85 \times 10^{-14} \ (F/cm) \times 3.9}{7000 \times 10^{-8} \ cm}$$

$$\doteqdot 0.49 \ (pF) \qquad \cdots \quad (2)$$

If any stray capacitance of such a value is present in the electrode pad, a high speed operation is prevented, and therefore, an important problem may occur in the semiconductor integrated circuit device for a high frequency signal processing wherein, for example, about 10 GHz or more is required as a cutoff frequency fT.

In a conventional semiconductor circuit device having a two-level interconnection structure, an electrode pad is provided as shown in Fig. 4. That is, a collector lead-out electrode 38 is used as a first interconnection layer, and an electrode pad 41, comprised of a second interconnection layer (metal wiring layer) having the similar size to that of the first interconnection layer, is directly in contact with the collector lead-out electrode 38 through an opening 40 formed in a part of a surface passivation film 39.

In Fig. 4, reference numeral 42 denotes an interlevel insulator, and 43 denotes an emitter wiring layer,

2

for example, formed of the second interconnection layer. In other components shown in Fig. 4, the same reference numerals are employed to designated components corresponding to those shown in Fig. 3.

In the electrode pad section provided in Fig. 4, a MOS capacitor is also provided by the second interconnection layer, the first interconnection layer, the insulating film and the epitaxial layer. A capacitance value C of the MOS capacitor has a substantially similar value to that given by the equation (2), thus degrading the high speed operation characteristics.

In order to eliminate such a degradation problem, it may usually be considered that, in order to lower the capacitance value C of the MOS capacitor, the thickness d of the insulating film is increased of the area A of the electrode pad is reduced.

With an increase in the thickness d of the insulating film provided on the surface of the epitaxial layer, the thickness step of the insulating film may be increased at contact portions of circuit elements. Accordingly, unwanted constriction or disconnection of the interconnection layers may occur. Further, since the area A of the electrode pad requires a predetermined area, depending upon the accuracy of the bonding technique, it may be difficult to make such an area extremely small. Therefore, it may be considered that the electrode pad is reduced to a certain extent by making it octagonal or circular in configuration. If, in this case, the area A of a square electrode is given by $x^2$, the area A of the octagonal electrode is given by about 0.83 $x^2$ and that of the circular electrode is about 0.79 $x^2$, respectively. At any rate, the capacitance values C of the MOS capacitors are slightly lowered to 83 % and 79 %, respectively.

Accordingly, it is an object of the present invention to provide a semiconductor integrated circuit device with a multilevel interconnection structure for greatly reducing a stray capacitance produced in an electrode pad to improve high frequency signal processing characteristics, without adding any specific manufacturing step and/or without requiring any bonding technique of high accuracy.

According to one aspect of the present invention, there is provided a semiconductor integrated circuit device with a multilevel interconnection structure, which includes upper interconnection layers provided above lower interconnection layers through an interlevel insulator. A part of at least one of upper interconnection layers disposed on the interlevel insulator is used as an electrode pad to reduce an unwanted stray capacitance between the electrode pad and a semiconductor substrate, thereby improving high frequency signal processing characteristics of the device.

This invention can be more fully understood from the following detailed description when taken in conjunction with the accompanying drawings, in which:

The novel and distinctive features of the invention are set forth in the claims appended to the present application. The invention itself, however, together with further objects and advantages thereof may best be understood by reference to the following description and accompanying drawings in which:

Fig. 1 is a plan view showing a bipolar transistor and an electrode pad in a semiconductor integrated circuit device having a multilevel interconnection structure according to an embodiment of the present invention;

Fig. 2 is a cross-sectional view of the semiconductor integrated circuit device, taken along line II-II of Fig. 1;

Fig. 3 is a cross-sectional view showing a bipolar transistor and an electrode pad in a conventional semiconductor integrated circuit device; and

Fig. 4 is a cross-sectional view showing a bipolar transistor and an electrode pad in a conventional semiconductor integrated circuit device having a multilevel interconnection structure.

A semiconductor integrated circuit device according to an embodiment of the present invention will be explained below in conjunction with its electrode pad.

Fig. 1 shows a plane pattern of a bipolar transistor and an electrode pad in a semiconductor integrated circuit device having a two-level interconnection structure, and Fig. 2 is a cross-sectional view taken along line II-II in Fig. 1.

In Fig. 2, the same reference numerals as shown in Fig. 4 are employed to designated components corresponding to those in the semiconductor integrated circuit device with the two-level interconnection structure except for the electrode pad structure shown in Fig. 2 which is different from that shown in Fig. 4.

In the semiconductor integrated circuit device shown in Fig. 2, reference numeral 30 denotes a p-type semiconductor substrate, 31 an $n^+$-type buried layer, 32 an n-type epitaxial layer for providing a collector region C of a bipolar transistor, 33 a $p^+$-type isolation region provided so as to surround an island-like bipolar transistor area in the epitaxial layer, B a base region formed in a bipolar transistor region, E an emitter region formed in the base region, 34 an $n^+$-type contact region being in contact with the epitaxial layer, 35 a first insulating film, such as an $SiO_2$ film, formed on the epitaxial layer surface, 36 a base lead-out electrode comprised of a first interconnection layer being in contact with the base region B through a base opening in the first insulating film 35, 37 an emitter electrode comprised of a first interconnection layer

3

being in contact with an emitter region E through an emitter opening in the first insulating film 35, 38 a collector lead-out electrode comprised of a first interconnection layer being in contact with the contact region 34 through a collector opening in the first insulating film 35, 42 an interlevel insulator, such as a CVD SiO$_2$ film, formed on the first interconnection layer, 43 a second interconnection layer (metal wiring layer) formed on the interlevel insulator 42, and 44 an electrode pad comprised of the second interconnection layer provided on the interlevel insulator 42, respectively. A part of the electrode 44 is in contact with a part of the collector lead-out electrode 38 through an through-hole, and an opening 40 is formed in an surface passivation film 39 covering the second interconnection layers.

In Fig. 1, BT denotes a bipolar transistor (NPN transistor in the embodiment), EC an emitter contact region, BC a base contact region, CC a collector contact region, 11 a contact region between the emitter wiring layer 43 and the emitter electrode 37, and 12 a contact region between the electrode pad 44 and the collector lead-out electrode 38, respectively.

In the electrode pad structure, a MOS capacitor is provided by the second interconnection layer, the interlevel insulator, the first insulating film and the epitaxial layer, and a thickness of an insulating film between the electrode pad and the semiconductor substrate becomes the sum of the thickness of the interlevel insulator 42 and that of the first insulating film 35. Further, since it is usually set that the interlevel insulator 42 is thicker than the first insulating film 35, it can be possible to remarkably reduce the capacitance value C of the MOS capacitor.

If the electrode area A, the thickness d of the first insulating film 35, the thickness $d_2$ of the interlevel insulator 42 and the relative dielectric constant $\epsilon$ (the first insulating film 35 and the interlevel insulator 42 are formed of the SiO$_2$ film.) are given by A = 100 $\mu$m × 100 $\mu$m, d = 7000 Å, $d_2$ = 10000 Å and $\epsilon$ = 3.9, respectively,, the capacitance value C of the MOS capacitor will become

$$C = A \cdot \frac{\varepsilon_0 \cdot \varepsilon}{d + d_2}$$

$$= 10^{-4} (cm^2) \times \frac{8.85 \times 10^{-14} \ (F/cm) \times 3.9}{(7000 + 10000) \times 10^{-8} \ (cm)}$$

$$\doteqdot 0.20 \ (pF) \qquad\qquad \dots (3)$$

since the dielectric contact $\epsilon_0$ in vacuum is 8.85 × 10$^{-14}$ F/cm.

This value C is greatly reduced to approximately 31%, compared to the value of the equation (2) of the conventional example.

For providing the electrode pad of the structure, it is not necessary to add any extra specific process to the process of making of the conventional semiconductor integrated circuit device having the two-level interconnection structure. Further, any high accuracy bonding technique is not required.

As the first insulating film 35 of the embodiment, a two-layer structure having a nitride film formed on the SiO$_2$ film may be used. Further, the interlevel insulator 42 may not be limited to the SiO$_2$ film. As the first layer interconnection layers, metal layers or semiconductor films, such as polysilicon films, or a metal/semiconductor films, such as a molybdenum/silicide films, may be employed.

The present invention is not limited to the semiconductor integrated circuit device having the two-level interconnection structure. The electrode pad may be provided by an upper interconnection layer or wiring layer disposed on an upper interlevel insulator so that interlevel insulators and the insulating film formed on the substrate surface are arranged between the electrode pad and the semiconductor substrate. Accordingly, the present invention is applicable to semiconductor integrated circuit devices having a three-level or multilevel connection structure. In this case, the electrode pad may be in contact with the lowest lead-out electrode or in contact with the lowest lead-out electrode through an intermediate wiring layer.

According to the present invention as described above, the thickness of the insulating film between the electrode pad and the semiconductor substrate is given by the sum of the thickness of the interlevel insulator and that of the insulating film formed on the substrate surface, and the interlevel insulator is so set as to be thicker than the insulating film formed on the substrate surface. Accordingly, the capacitance value of the MOS capacitor produced by the bonding pad will be remarkably reduced without adding any extra manufacturing step and/or without requiring any high accuracy bonding technique, etc., thereby providing semiconductor integrated circuit devices with the multilevel interconnection structure having the improved high frequency signal processing characteristics.

It is further understood by those skilled in the art that the foregoing description is a preferred embodiment of the disclosed device and that various changes and modifications may be made in the invention without departing from the spirit and scope thereof.

Reference signs in the claims are intended for better understanding and shall not limit the scope.

**Claims**

1. A semiconductor integrated circuit device comprising a plurality of circuit elements provide in a semiconductor substrate (30), isolation regions (33) for electrically isolating said circuit elements from one another, a multilevel interconnection structure having upper and lower interconnection layers (43, 44) (36, 37, 38) and an interlevel insulator (42) provided between said upper and lower interconnection layers, and electrode pads (44) provided above said semiconductor substrate,

   characterized in that a part of at least of said upper interconnection layers (44) provided on said interlevel insulator (42) is used as each of said electrode pads (44).

2. The semiconductor integrated circuit device according to claim 1,

   characterized in that said electrode pads (44) are provided above a periphery of said semiconductor substrate (30).

3. The semiconductor integrated circuit device according to claim 2,

   characterized in that each of said electrode pads (44) is provided at an end portion of at least one of said upper interconnection layers (44).

4. The semiconductor integrated circuit device according to claim 1,

   characterized in that each of said electrode pads (44) is provided on each of said interlevel insulator (42).

5. The semiconductor integrated circuit device according to claim 1,

   characterized in that said electrode pads (44) are square.

6. The semiconductor integrated circuit device according to claim 1,

   characterized in that said upper interconnection layers (43, 44) are covered with a surface passivation layer (39) except said electrode pads (44).

7. The semiconductor integrated circuit device according to claim 1,

   characterized in that said lower interconnection layers (36, 37, 38) are provided on an insulating film (35) formed on said semiconductor substrate (30).

8. The semiconductor integrated circuit device according to claim 1,

   characterized in that a total thickness of an insulating film located between each of said electrode pads (44) and said semiconductor substrate (30) is the sum of a thickness of said interlevel insulator (42) and a thickness of said insulating film (35).

9. The semiconductor integrated circuit device according to claim 1,

   characterized in that each of said circuit elements is comprised of a bipolar transistor having emitter, base and collector regions (E, B, C).

10. The semiconductor integrated circuit device according to claim 9,

    characterized in that said emitter, base and collector regions (E, B, C) are electrically connected to said lower interconnection layer (36, 37, 38).

11. The semiconductor integrated circuit device according to claim 9,

    characterized in that said collector region (C) is electrically connected to one of said upper interconnection layers (44).

12. The semiconductor integrated circuit device according to claim 7,

    characterized in that said interlevel insulator (42) is thicker than said insulating film (35).

## F I G. 1

## F I G. 2

F I G. 3

F I G. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | PATENT ABSTRACTS OF JAPAN vol. 8, no. 36 (E-227)(1473) 16 February 1984, & JP-A-58 192350 (HITACHI SEISAKUSHO K.K.) 09 November 1983, * the whole document * | 1-4,6-8,5, 12 | H 01 L 21/60 H 01 L 23/485 H 01 L 23/522 |
| X,A | INTERNATIONAL ELECTRON DEVICES MEETING IEDM 1981 07 December 1981, WASHINGTON DC, US pages 62 - 65; K. MUKAI et al.: "A new integration technology that enables forming bonding pads on active areas" * page 62, right-hand column; figures 1, 2 * * page 63, right-hand column; figure 7 * | 1,4-8,12, 2,3,9 | |
| Y,A | EP-A-0 019 883 (TOKYO SHIBAURA DENKI K.K.) * page 1, line 5 - page 2, line 16 * * page 4, lines 5 - 21; claim 1; figures 3a, 3b * | 5,12,1-4, 7-10 | |
| A | PATENT ABSTRACTS OF JAPAN vol. 10, no. 117 (E-400)(2174) 02 May 1986, & JP-A-60 250651 (SUWA SEIKOSHA K.K.) 11 December 1985, * the whole document * | 1-8,12 | |
| A | EP-A-0 260 906 (FUJITSU LTD.) * column 9, line 15 - column 10, line 4; figure 5A * | 1-4,6-8 | TECHNICAL FIELDS SEARCHED (Int. Cl.5) H 01 L |
| A | DE-A-3 116 406 (HITACHI LTD.) * page 14, line 29 - page 15, line 27; figures 14, 15 * | 1-4,6,8 | |
| A | PATENT ABSTRACTS OF JAPAN vol. 3, no. 81 (E-122) 12 July 1979, & JP-A-54 057980 (SONY K.K.) 10 May 1979, * the whole document * | 1,4 | |

The present search report has been drawn up for all claims

| Place of search | Date of completion of search | Examiner |
|---|---|---|
| Berlin | 07 June 91 | KLOPFENSTEIN P R |